Europäisches Patentamt

European Patent Office

Office européen des brevets

(19)

(11) Publication number: **0 242 224**
**A1**

(12) **EUROPEAN PATENT APPLICATION**

(21) Application number: **87303409.4**

(22) Date of filing: **16.04.87**

(51) Int. Cl.⁴: **G 01 R 1/067**

(30) Priority: **18.04.86 JP 90949/86**
**26.12.86 JP 200033/86**

(43) Date of publication of application: **21.10.87**
**Bulletin 87/43**

(84) Designated Contracting States: **DE FR GB IT NL**

(71) Applicant: **SAGAMI TSUSHIN KOGYO KABUSHIKI KAISHA, 370 Enzo, Chigasaki-shi Kanagawa (JP)**

(72) Inventor: **Nansai, Takashi, 3-1-12 Shonandai, Fujisawa-shi Kanagawa (JP)**

(74) Representative: **Rees, David Christopher et al, Kilburn & Strode 30 John Street, London WC1N 2DD (GB)**

(54) **Printed wiring board tester.**

(57) A probe pin comprises three pin elements. A first pin element (1) includes a greater diameter section (11) which has one end provided with a contact portion for engagement with the terminal area of a printed wiring board to be tested and the other end formed with a stepped portion (11b), and a smaller diameter section (12) which is integral with the greater diameter section (11) through the stepped portion (11b). A second pin element (2) has at one end a cylindrical portion (21) fitted on the smaller diameter section (12) of the first pin element (1) and at the other end a cord connecting portion (22). The cylindrical portion (21) is formed at its inlet end with a stopper jaw (21a). A third pin element (3) is made of a coiled spring which has one end engaging with the stopper jaw (21a) and is loosely fitted around the periphery of the second pin (2).

A plurality of the probe pins are mounted on fixture members so that the third pin element (3) in each case is located between the first and second fixture members.

# PRINTED WIRING BOARD TESTER

The present invention relates to a tester for a printer wiring board or printed circuit board. It is particularly concerned with improvements in a probe pin adapted to be used in a printed wiring board tester and a printed wiring board which uses such an improved probe pin.

A printed wiring board tester is used to examine electrical conductive relationship between any two points in terminal areas on individual printed wiring boards. That is, it is used to determine whether or not two points in terminal areas are in a conductive state or not, in order to distinguish any flowed electrical connection from a sound electrical connection.

The printed pattern formed on a printed wiring board and the disposition of groups of terminal areas can vary since there is no standardisation of its lattice spacing. Thus, printed wiring boards which have various values of spacings exist, and in some cases the same size of printed wiring boards have various lattice pitches. Therefore, for testing, an exclusive fixture would normally be required for every printed wiring board to be examined.

Conventionally, in order to avoid this disadvantage, a tester which is provided with, for example, a 0.1 inch (2.54mm) lattice spacing as a standard is used, and adaptors for other kinds of printed wiring board to be examined are chosen, to enable testing of various kinds of printed wiring boards to be carried out.

However, when these adaptors are used, the probe pins engage the terminal areas of the printed wiring board through adaptor pins indirectly, resulting in poor contact. In addition, the operation of tester is not as simple, resulting in increased time and labour being required for testing and for preparation before testing.

The present inventor has realised that when an exclusive fixture is used, without any adaptor, good results with high reliability are obtained. However, very high costs are incurred in the manufacture of exclusive fixtures since the probe pins used are complicated in their construction. The present invention therefore seeks primarily the simplification of this construction.

Although there are various kinds of spring probe, they all fundamentally comprise four members, that is, a probe body whose head engages the terminal areas, a coiled spring engaging the probe body, a first case member telescopically holding the probe body through the coiled spring, and a second member having a cable at one end and removably inserted in the first case member. Consequently, a conventional probe pin has many components and a conventional printed wiring board tester which uses these many components involves high manufacturing costs. Furthermore, the probe pin itself is complicated, as mentioned above, with a very small coiled spring functioning as a spring and as a portion of the electrical circuit by being inserted into the first case member and engaging the lower end of the probe body, resulting in many difficulties and a great deal of time required for manufacture. Since printed wiring boards are rapidly becoming more miniaturised and the lattice spacings of the through-holes are becoming smaller due to high density development, it is clear that the above-mentioned disadvantages are liable to increase.

Consequently, with the above-mentioned conventional probe pin construction, a printed wiring board tester which fulfils pneumatic and mechanical functions with high reliability cannot be expected.

The present invention seeks to overcome the above-mentioned disadvantages, and an object of the present invention is to provide a novel probe pin which is simple in construction and easily assembled, and also to provide a printed wiring board tester which uses probe pins of such a construction.

It is another object of the present invention to provide a novel probe pin in which a coiled spring constituting a portion of the probe pin is present merely to provide its spring force without forming a portion of electrical circuit so that the probe pin is not affected by a variable contact resistance due to movement of the coiled spring, and again to provide a printed wiring board tester which uses probe pins of such a construction.

According to the invention, there is provided a probe pin for printed wiring board tester characterised by: a first pin element including a first section having a relatively greater diameter section integrally connected to a second section having a relatively smaller diameter through a stepped portion. The first section having a contact portion arranged to engage the terminal area of a printed wiring board to be tested; a second pin element having at one end a cylindrical portion fitted on the second section of the said first pin element and having an electrical connecting portion

4

at its other end, the end of the cylindrical portion
being formed with a stop; and a third pin element
comprising a coiled spring, which is loosely fitted
around the periphery of the second pin element and one
end of which is in engagement with the stop of the
second pin element.

Preferably, the cylindrical portion of the second
pin element, including the stop, is formed with a
longitudinal slit. Preferably, the electrical
connecting portion of the second pin element is smaller
in diameter than the cylindrical portion.

The invention also extends to a printed wiring
board tester comprising first and second fixture
members which are generally parallel to and spaced from
each other and have a plurality of probe pins as
described above extending through them. Preferably,
the third pin element in each case is located between
the fixture members. Preferably, the first section of
the first pin element and the cylinder portion of the
second pin element extend through bearings in the
fixture members.

According to a preferred embodiment of the
invention therefore, there may be provided a printed
wiring tester which comprises; probe pins, each probe
pin comprising a first pin element including a greater
diameter section having one end provided with contact
portion engaged with the terminal area of a printed
wiring board to be tested and having the other end
formed with a stepped portion and a smaller diameter
section integral with the greater diameter section
through the stepped portion, a second pin element
having at its one end a cylindrical portion fitted on
the smaller diameter section of the first pin element and having a cord connecting portion at the other end with the cylindrical portion being formed at its inlet end with a stopper jaw and the cylindrical portion including the stopper jaw being formed with a slit in a longitudinal direction, and a third pin element made of a coiled spring having one end in engagement with the stopper jaw of the second pin element and loosely fitted on the peripheral portion of the second pin element, and first and second fixture members spaced from each other and generally parallel with each other, a plurality of the probe pins extending movably through the first and second fixture members so that the third pin element is located between the first and second fixture members.

Present invention displays a number of advantageous features.

Firstly, the probe pin according to the present invention comprises first, second and third pin elements, and therefore the number of parts is less than in the case of a conventional probe pin. In addition, each of these elements is of such a simple construction that it can be easily manufactured, which brings down the production costs.

Secondly, since a conventional probe pin uses a coiled spring as part of the electric circuit, the opposite ends of the spring function as movable contact portions, resulting in an increased and variable resistance. On the other hand, in the present invention, the coiled spring is used merely for its spring force without using it as a conductor, and so it is not necessary to consider contact resistance nor its variation at all.

Thirdly, since, in the present invention, the coiled spring is loosely fitted around the peripheral portion of the probe pin body (the second pin element), a coiled spring of greater diameter can be used, thereby increasing the reliability of operation of the probe. In addition, manufacturing, working, and assembly are all made easier. In particular, since the diameter of probe pin itself must become smaller in response to the fact that the lattice spacings of the probe pin have been becoming smaller and smaller, a conventional type of probe pin with a coiled spring mounted in the pipe as mentioned above cannot cope with these demands. However, it is clear that a probe pin according to the present invention will be able to answer the expected demands.

Furthermore, since the three elements according to the present invention are simple in construction and assembled as mentioned above, no trouble should occur at all, and a long life should be expected.

Furthermore, since, in the present invention, the second pin element is formed with a slit, the first and second elements can be rigidly connected to each other due to resilience in the second pin element, and the contact resistance will be small.

Furthermore, where the probe pins are assembled in the fixtures, since the coiled spring of the third pin element can be prepared, having various forces and therefore can be selectively used, a constant spring force can be imparted easily to all the probe pins.

Finally, since the probe pin according to the present invention can be mounted with respect to the fixtures through bearings, the wear on the fixtures and the probe pin can be reduced and at the same time, the occurrence of static electricity can be suppressed or eliminated, thereby providing a printed wiring board tester of high reliability.

The present invention may be carried into practice in various ways and some embodiments will now be described by way of example with reference to the accompanying drawings in which:

Figure 1 is a front view of a first embodiment of a probe pin according to the present invention with the coiled spring removed;

Figure 2 is an exploded front view of the first embodiment;

Figure 3 is a front view showing the operation of mounting the probe pin of the first embodiment on to fixtures;

Figure 4 is a front view of the second embodiment with the first and second pin elements being separated and the third pin element removed;

Figure 5 is a front view of the second embodiment with the first and second pin elements connected and the third pin element removed; and

Figure 6 is a cross-sectional view of a main portion of the printed wiring board tester using a probe pin according to the present invention.

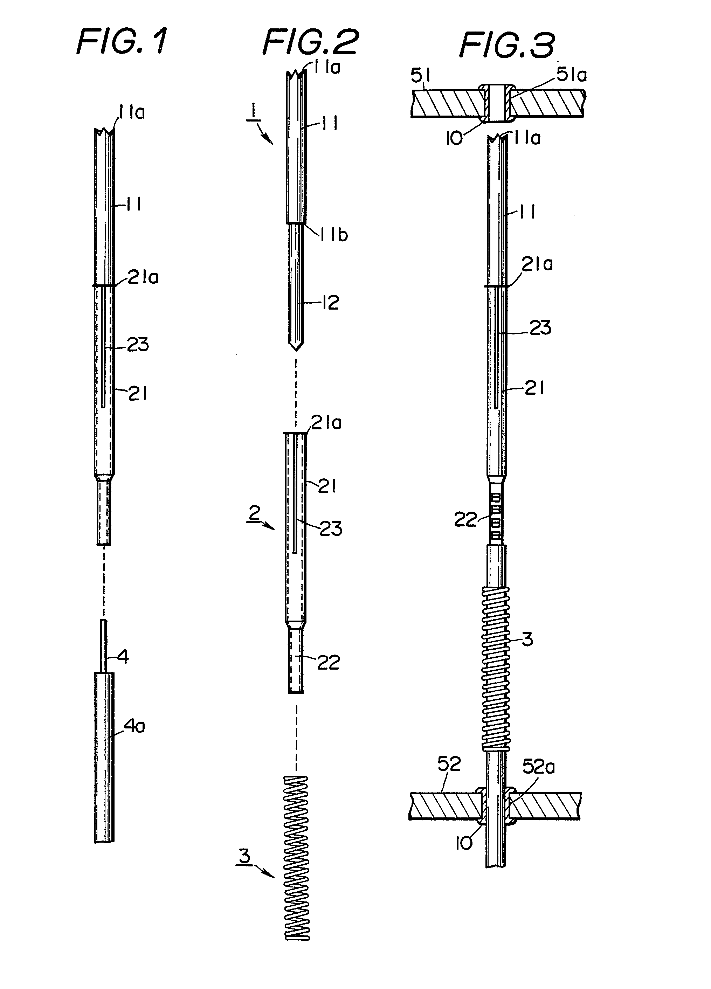

Referring firstly to Figures 1 to 3, a probe pin for a printed wiring board tester of a first embodiment according to the present invention comprises a first pin element 1, a second pin element 2 and a third pin element 3.

The first pin element 1 comprises a cylindrical section of greater diameter 11 and a cylindrical section of smaller diameter 12, integrally connected by a stepped portion 11b. The larger section 11 has a contact portion 11a engaged with the terminal area of the board to be tested or examined.

The second pin element 2 comprises a hollow cylindrical portion of greater diameter 21 which the smaller diameter portion 12 of the first pin element 1 fits into, and a smaller diameter cylindrical cord connecting portion 22 in which a cord 4 is crimped. The greater diameter portion 21 is formed at its end with a stopper jaw 21a which the stepped portion 11b of the first pin element 1 and one end of the third pin element 3 engage. The stopper jaw 21a engages the lower surface of a bearing 10 located in a through-hole 51a in a fixture member 51 when the probe pin is inserted in the bearing 10. It therefore also functions as a stop for limiting further upward movement of the probe pin (see Figure 3). The greater cylinder portion 21 is formed with a longitudinal slit 23.

The third pin element 3 comprises a coiled spring which is loosely fitted around the outer peripheral portion of greater cylinder portion 21 of the second pin element 2. To this end, various kinds of coiled springs which have different spring forces can be used.

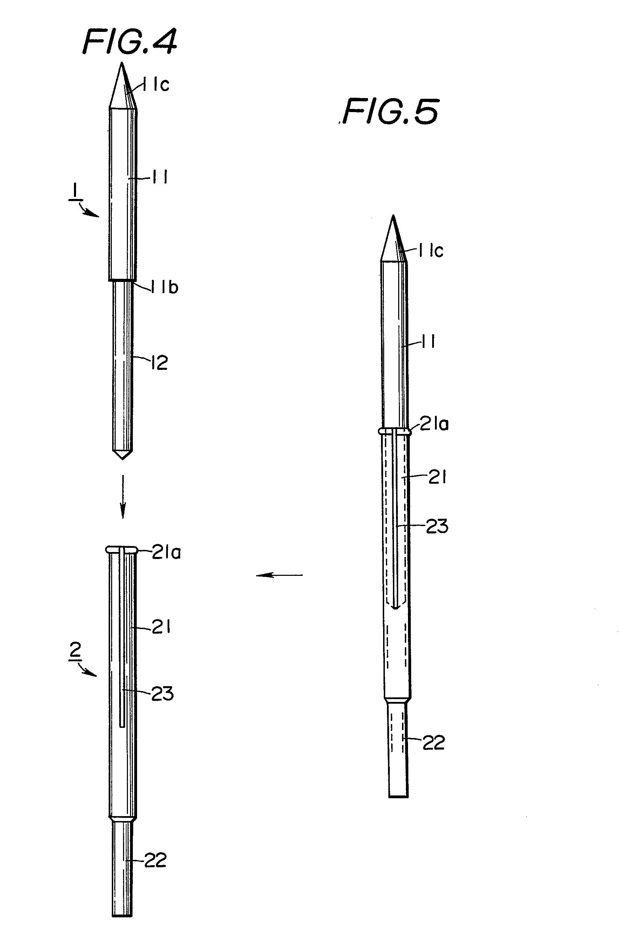

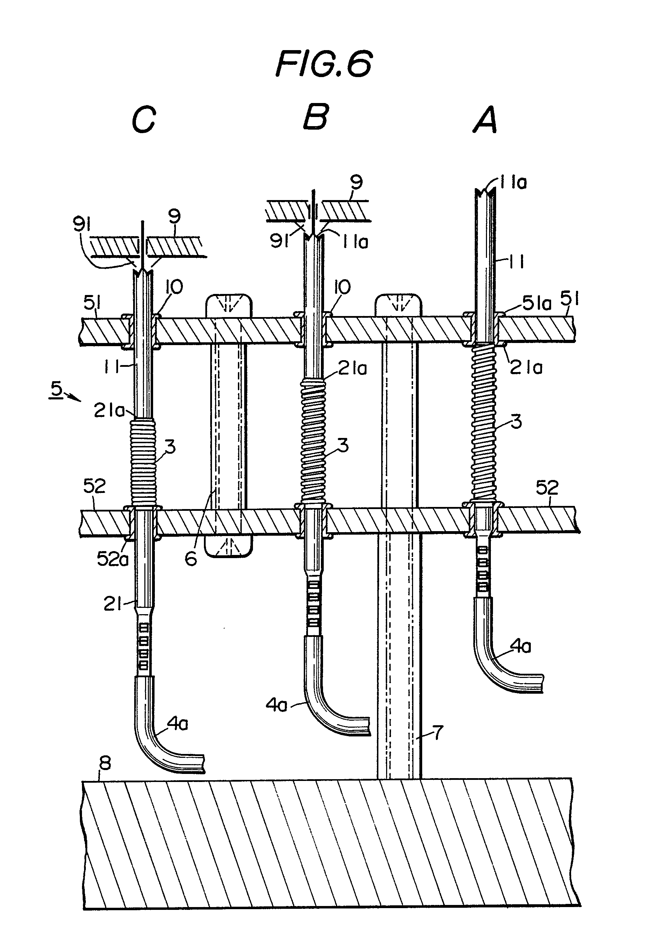

The probe pin is mounted on the fixtures of the printed wiring board tester, as shown in Figure 6. Firstly, the smaller cylinder portion 12 of the first pin element 1 is rigidly inserted into the greater cylinder portion 21 of the second pin element 2. Then, the cord 4 is inserted and crimped in the cord connecting portion 22 of the second pin element 2 and the coiled spring of the third element 3 is loosely fitted around the greater cylinder portion 21 of the second pin element. Alternatively, after the coiled spring has been loosely fitted around the greater cylinder portion 21, the cord 4 is connected to the connecting portion 22. Thus, the probe pin 1 is assembled. The assembled probe pins are then inserted for vertical movement in respective bearings 10, located in the through-holes 51a, 52a, provided in the fixture members 51, 52 in a lattice pattern.

Figure 6 is a particular cross-sectional view showing an example of a fixture 5 incorporating probe pins 1 according to the present invention. The fixture 5 comprises the fixture members 51,52. A spacer 6 determines a distance between the fixture members 51 and 52. A further spacer 7 has a stud for attaching the fixture 5 to a base 8. Reference numeral 9 designates the board to be examined.

The probe pin in position A is in a stationary or normal state in which the coiled spring or the third pin element 3 extends between the fixture members 51 and 52. Positions B and C show that the mounted board 9 to be examined is located above the fixture 5, the terminal area 91 of the board 9 engages the connecting portion 11a of the probe pin, and the probe pin is urged upwards for examination. As shown, the coiled spring 3 is compressed between the stopper jaw 21a and the fixture member 52, and therefore its resilience pushes the pin upwards, resulting in a pressure engagement of the connecting portion 11a to the terminal area 91.

Although the first pin element 1 may be required to be replaced due to wear of the connecting portion 11a, since the first pin element 1 is removably fitted in the second pin element 2, the first and second pin elements 1 and 2 can be easily separated from each other and thus the first pin element is easily replaceable. On the other hand, since the first and second pin elements are moved toward each other by the action of the spring force, the pin elements so not tend to separate during examination.

Figures 4 and 5 show a second embodiment according to the present invention. Whereas the first embodiment is directed to examination of a mounted board, the second embodiment is for use in situations in which the board and electrical elements are not mounted. Therefore, in the second embodiment, the first pin element has its end formed with a conical-shaped connecting portion 11c instead of the connecting portion 11a of the first pin element. The other elements including the second and third elements, are the same as in the case of the first embodiment, and a detailed description is therefore not necessary.

CLAIMS

1. A probe pin for printed wiring board tester characterised by: a first pin element (1) including a first section (11) having a relatively greater diameter section integrally connected to a second section (12) having a relatively smaller diameter through a stepped portion (11a). The first section (11) having a contact portion (11a) arranged to engage the terminal area (91) of a printed wiring board (9) to be tested; a second pin element (2) having at one end a cylindrical portion (21) fitted on the second section (12) of the said first pin element (1) and having an electrical connecting portion (22) at its other end, the end of the cylindrical portion (21) being formed with a stop (21a); and a third pin element (3) comprising a coiled spring, which is loosely fitted around the periphery of the second pin element (2) and one end of which is in engagement with the stop (21a) of the second pin element (2).

2. A probe pin as claimed in Claim 1 characterised in that the cylindrical portion (21) of the second pin element (2), including the stop (21a), is formed with a longitudinal slit (23).

3. A probe pin as claimed in Claim 1 or Claim 2 characterised in that the electrical connecting portion (22) of the second pin element (2) is smaller in diameter than the cylindrical portion (21).

4. A printed wiring board tester (5) which comprises first and second fixture members (51,52) which are generally parallel to and spaced from each other, and a plurality of probe pins extending through the first and second fixture members characterised in that the pin members are as claimed in any preceding claim and the third pin element (3) is located between the first and second fixture members (51,52).

5. A tester as claimed in Claim 4 characterised in that the first section (11) of the first pin element (1) and the cylinder portion (21) of the second pin element (2) extend through bearings (10) in the fixture members (51,52).

FIG.1  FIG.2  FIG.3

FIG.4

11c

1

11

11b

12

2

21a

21

23

22

FIG.5

11c

11

21a

21

23

22

# FIG.6

0242224

# EUROPEAN SEARCH REPORT

European Patent Office

Application number

EP  87 30 3409

## DOCUMENTS CONSIDERED TO BE RELEVANT

| Category | Citation of document with indication, where appropriate, of relevant passages | Relevant to claim | CLASSIFICATION OF THE APPLICATION (Int Cl.4) |
|---|---|---|---|
| A | DE-A-3 136 896  (INGUN PRÜFMITTELBAU)<br>* abstract; figure 3 *<br><br>--- | 1,4 | G 01 R    1/067 |
| A | US-A-4 200 351  (E.J. LONG et al.)<br>* abstract; figures 1, 4, 6 *<br><br>----- | 1 | |

|  |
|---|
| **TECHNICAL FIELDS SEARCHED (Int Cl.4)** |
| G 01 R    1/067<br>G 01 R    1/073<br>H 01 R    11/18 |

The present search report has been drawn up for all claims

| Place of search | Date of completion of the search | Examiner |
|---|---|---|
| BERLIN | 30-06-1987 | LEMMERICH J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82